# EUROPEAN PATENT APPLICATION

(11) **EP 4 794 206 A1**
(43) Date of publication of application: **19.08.2026**
(21) Application number: 23956423.0
(22) Date of filing: 25.10.2023
(51) Int. Cl.: H03M 13/13, H04L 1/00

(54) **POLAR CODE ENCODING METHOD AND APPARATUS**

(71) Applicant: HUAWEI TECHNOLOGIES CO., LTD., Shenzhen 518129 (CN)
(72) Inventor: WANG, Xianbin, Shenzhen, Guangdong 518129 (CN); TONG, Jiajie, Shenzhen, Guangdong 518129 (CN); ZHANG, Huazi, Shenzhen, Guangdong 518129 (CN); QIN, Kangjian, Shenzhen, Guangdong 518129 (CN); LIU, Ke, Shenzhen, Guangdong 518129 (CN); WANG, Jun, Shenzhen, Guangdong 518129 (CN); TONG, Wen, Shenzhen, Guangdong 518129 (CN); DU, Yinggang, Shenzhen, Guangdong 518129 (CN)
(74) Representative: MERH-IP Matias Erny Reichl Hoffmann Patentanwälte PartG mbB
(86) International application number: PCT/CN2023/126567
(87) International publication number: WO 2025/086171

(57) **Abstract**

This application provides a polar-code coding method and an apparatus. In this method, nested extraction is performed on a sequence number whose value is greater than or equal to (M-N) from a first sequence, to obtain a first subset including sequence numbers of N channels, a second sequence with a length of N is determined based on the first subset, and polar encoding is performed based on the second sequence. In this method, there is no need to store one sequence for each length. A latter portion of the first sequence is extracted, so that subsequences with different lengths can be obtained through nested extraction to construct a codeword. This increases nested extraction flexibility, and reduces polar code construction complexity.

## Description

### TECHNICAL FIELD

This application relates to the field of communication technologies, and in particular, to a polar-code coding method and an apparatus.

### BACKGROUND

Polar (polar) code is the first channel coding scheme that can be rigorously proved to "achieve" Shannon channel capacity, offering both excellent error-correction performance and low-complexity decoding.

In wireless communication, a flexible code length and code rate are usually required, with code lengths such as 16, 32, ..., 1024. If polar codes are constructed based on a reliability sequence, one sequence needs to be stored for each code length. This results in excessive storage overheads, and increases the complexity of polar code construction.

Therefore, how to increase flexibility of nested extraction of polar codes to reduce the complexity of polar code construction is a hot topic in current research.

### SUMMARY

Embodiments of this application provide a polar-code coding method and an apparatus, to improve flexibility of nested extraction of polar codes and reduce polar code construction complexity.

To achieve the foregoing objectives, this application uses the following technical solutions.

According to a first aspect, a polar-code coding method is provided. The method includes: obtaining a first sequence, where the first sequence includes sequence numbers of M channels, and the sequence numbers of the M channels are arranged in the first sequence in ascending order of channel reliability; performing polar encoding based on a second sequence to obtain first encoded data, where the second sequence includes sequence numbers of N channels, the second sequence is determined based on a first subset of the first sequence, the first subset includes N sequence numbers, and a value of the sequence number in the first subset is greater than or equal to (M-N); and outputting the first encoded data.

It can be learned from the method according to the first aspect that, nested extraction is performed on a sequence number whose value is greater than or equal to (M-N) from the first sequence, to obtain the first subset including the sequence numbers of the N channels, the second sequence with the length of N is determined based on the first subset, and polar encoding is further performed based on the second sequence. In this way, there is no need to store one sequence for each length. A latter portion of the first sequence is extracted, so that subsequences with different lengths may be obtained through nested extraction to construct a codeword. This increases nested extraction flexibility, and reduces polar code construction complexity.

It may be understood that the method according to the first aspect may be performed by a first communication apparatus, and the first communication apparatus may be a terminal, an apparatus including a terminal, or a chip in a terminal. Alternatively, the first communication apparatus may be a network device, an apparatus including a network device, or a chip in a network device. For ease of description, the following uses an example in which the method according to the first aspect is performed by the first communication apparatus for description.

In a possible design solution, the method according to the first aspect may further include: performing, corresponding to data retransmission, polar encoding based on a third sequence to obtain second encoded data, where the third sequence includes sequence numbers of N1 channels, the third sequence is determined based on a second subset of the first sequence, the second subset includes N1 sequence numbers, the third sequence corresponds to the second sequence, and N is less than or equal to N1. The correspondence herein may be that the second sequence corresponds to a latter portion of the third sequence. In other words, the second sequence is nested in the third sequence. This can ensure that an information bit position selected during the data retransmission is a subset of an information bit position selected during initial data transmission, and avoid a case in which an information bit position that is not selected during the initial data transmission is selected as an information bit position during the data retransmission. This simplifies implementation of a decoder during the data retransmission, and can adapt to a requirement of the data retransmission.

In a possible design solution, that the second sequence is determined based on the first subset of the first sequence includes: The second sequence is the first subset of the first sequence; or the second sequence is the same as a sequence obtained by subtracting (M-N) from a value of each sequence number in the first subset of the first sequence. It may be understood that the first subset is a subsequence of the first sequence, and the first subset may be directly used as the second sequence, or the second sequence is obtained by subtracting (M-N) from the value of each sequence number in the first subset, thereby increasing the nested extraction flexibility.

In a possible design solution, that the third sequence is determined based on the second subset of the first sequence includes: The third sequence is the second subset of the first sequence; or the third sequence is the same as a sequence obtained by subtracting (M-N1) from a value of each sequence number in the second subset of the first sequence. It may be understood that the second subset is a subsequence of the first sequence, and the second subset may be directly used as the third sequence, or the third sequence is obtained by subtracting (M-N) from the value of each sequence number in the second subset, thereby increasing the nested extraction flexibility.

Optionally, the value of the sequence number in the second subset of the first sequence is greater than or equal to (M-N1). Nested extraction is performed on a sequence number whose value is greater than or equal to (M-N1) from the first sequence, to obtain the second subset including the sequence numbers of the N1 channels. In this way, subsequences with different lengths may be obtained through nested extraction to construct a codeword. This increases the nested extraction flexibility, and reduces polar code construction complexity.

Optionally, the first subset is determined from the second subset. In other words, the second subset may be first obtained through nested extraction from the first sequence, and then the first subset is nestedly determined from the second subset, thereby increasing the nested extraction flexibility.

Optionally, sequence numbers in the second subset of the first sequence are N1 consecutive sequence numbers in the first sequence. Further, the N1 consecutive sequence numbers include N1 consecutive sequence numbers starting from an (n×N1)^{th} sequence number, and n is an integer greater than or equal to 0. A subsequence including N1 consecutive channels is extracted from the first sequence, thereby reducing the polar code construction complexity.

Optionally, the second subset of the first sequence includes N1 sequence numbers, whose values are less than N1, in the first sequence. The N1 sequence numbers whose values are less than N1 are extracted from the first sequence to construct the third sequence, thereby reducing the polar code construction complexity.

In a possible design solution, the performing, corresponding to the data retransmission, polar encoding based on the third sequence to obtain the second encoded data includes: corresponding to the data retransmission, obtaining K information bits; and performing polar encoding on the K information bits based on the second sequence and the third sequence to obtain the second encoded data. This reduces encoding complexity.

Optionally, performing polar encoding based on the second sequence and the third sequence to obtain the second encoded data includes: constructing a first information bit position set based on the second sequence, and constructing a second information bit position set based on the third sequence, where the first information bit position set includes K channels corresponding to K sequence numbers in descending order of reliability indexes in the second sequence, the second information bit position set includes K channels corresponding to K sequence numbers in descending order of reliability indexes in the third sequence, and K is a positive integer; extracting a channel corresponding to a sequence number, whose value is less than (N1-N), in the second information bit position set, to obtain a first information bit position subset; subtracting the second information bit position set from a third information bit position set, to obtain a second information bit position subset, where a channel sequence number i in the third information bit position set is in a one-to-one correspondence with a channel sequence number j in the first information bit position set; and performing polar encoding on the K information bits based on the first information bit position set, the second information bit position set, the first information bit position subset, and the second information bit position subset, to obtain the second encoded data.

It may be understood that the K information bits are placed in the first information bit position set and the second information bit position set, and then the first information bit position subset and the second information bit position subset are determined according to a simple set operation method, where the first information bit position subset and the second information bit position subset are corresponding information bit positions. In this way, two subsets can be quickly obtained, thereby reducing the polar code construction complexity, and further reducing the encoding complexity.

According to a second aspect, a polar code decoding method is provided. The method includes: obtaining first to-be-decoded information; decoding the first to-be-decoded information based on a second sequence, where the second sequence includes sequence numbers of N channels, the second sequence is determined based on a first subset of a first sequence, the first sequence includes sequence numbers of M channels, the sequence numbers of the M channels are arranged in the first sequence in ascending order of channel reliability, the first subset includes N sequence numbers, and a value of the sequence number in the first subset is greater than or equal to (M-N); and outputting data obtained through decoding of the first to-be-decoded information.

It may be understood that the method according to the second aspect may be performed by a second communication apparatus, and the second communication apparatus may be a terminal, an apparatus including a terminal, or a chip in a terminal. Alternatively, the second communication apparatus may be a network device, an apparatus including a network device, or a chip in a network device. For ease of description, the following uses an example in which the method according to the second aspect is performed by the second communication apparatus for description.

In a possible design solution, the method according to the second aspect may further include: corresponding to data retransmission, obtaining a second to-be-decoded information; decoding the second to-be-decoded information based on a third sequence, where the third sequence includes sequence numbers of N1 channels, the third sequence is determined based on a second subset of the first sequence, the second subset includes N1 sequence numbers, the third sequence corresponds to the second sequence, and N is less than or equal to N1; and outputting data obtained through decoding of the second to-be-decoded information.

In a possible design solution, that the second sequence is determined based on the first subset of the first sequence includes: The second sequence is the first subset of the first sequence; or the second sequence is the same as a sequence obtained by subtracting (M-N) from a value of each sequence number in the first subset of the first sequence.

In a possible design solution, that the third sequence is determined based on the second subset of the first sequence includes: The third sequence is the second subset of the first sequence; or the third sequence is the same as a sequence obtained by subtracting (M-N1) from a value of each sequence number in the second subset of the first sequence.

Optionally, the value of the sequence number in the second subset of the first sequence is greater than or equal to (M-N1).

Optionally, the first subset is determined from the second subset.

Optionally, sequence numbers in the second subset of the first sequence are N1 consecutive sequence numbers in the first sequence.

Further, the N1 consecutive sequence numbers include N1 consecutive sequence numbers starting from an (n×N1)^{th} sequence number, and n is an integer greater than or equal to 0.

Optionally, the second subset of the first sequence includes N1 sequence numbers, whose values are less than N1, in the first sequence.

In a possible design solution, the decoding the second to-be-decoded information based on the third sequence includes: decoding the second to-be-decoded information based on the second sequence and the third sequence.

Optionally, the decoding the second to-be-decoded information based on the second sequence and the third sequence includes: constructing a first information bit position set based on the second sequence, and constructing a second information bit position set based on the third sequence, where the first information bit position set includes K channels corresponding to K sequence numbers in descending order of reliability indexes in the second sequence, the second information bit position set includes K channels corresponding to K sequence numbers in descending order of reliability indexes in the third sequence, and K is a positive integer; extracting a channel corresponding to a sequence number whose value is less than (N1-N), in the second information bit position set, to obtain a first information bit position subset; subtracting the second information bit position set from a third information bit position set, to obtain a second information bit position subset, where a channel sequence number i in the third information bit position set is in a one-to-one correspondence with a channel sequence number j in the first information bit position set; and decoding the second to-be-decoded information based on the first information bit position set, the second information bit position set, the first information bit position subset, and the second information bit position subset.

It may be understood that, for related technical effects of the method according to the second aspect, reference may be made to the related descriptions in the first aspect. Details are not described herein again.

According to a third aspect, a communication apparatus is provided. The communication apparatus includes a module configured to perform the method according to either of the first aspect and the second aspect, for example, a transceiver module and a processing module. For example, the transceiver module indicates a transceiver function of the communication apparatus, and the processing module is configured to perform a function of the communication apparatus other than the transceiver function.

Optionally, the transceiver module may include a sending module and a receiving module. The sending module is configured to implement a sending function of the communication apparatus according to the third aspect, and the receiving module is configured to implement a receiving function of the communication apparatus according to the third aspect.

Optionally, the communication apparatus according to the third aspect may further include a storage module, and the storage module stores a program or instructions. When the processing module executes the program or the instructions, the communication apparatus is enabled to perform the method according to either of the first aspect and the second aspect.

It may be understood that the communication apparatus according to the third aspect may be a terminal or a network device, may be a chip (system) or another component or assembly that may be disposed in a terminal or a network device, or may be an apparatus that includes a terminal or a network device. This is not limited in this application.

In addition, for technical effects of the communication apparatus according to the third aspect, reference may be made to the technical effects in the first aspect. Details are not described herein again.

According to a fourth aspect, a communication apparatus is provided. The communication apparatus includes a processor, and the processor is configured to perform the method according to either of the first aspect and the second aspect.

In a possible design solution, the communication apparatus according to the fourth aspect may further include a transceiver. The transceiver may be a transceiver circuit or an interface circuit. The transceiver may be used by the communication apparatus according to the fourth aspect to communicate with another communication apparatus.

In a possible design solution, the communication apparatus according to the fourth aspect may further include a memory. The memory and the processor may be integrated together, or may be disposed separately. The memory may be configured to store a computer program and/or data in the method according to either of the first aspect and the second aspect.

In embodiments of this application, the communication apparatus according to the fourth aspect may be the terminal or the network device according to either of the first aspect and the second aspect, a chip (system) or another component or assembly that may be disposed in the terminal or the network device, or an apparatus that includes the terminal or the network device.

In addition, for technical effects of the communication apparatus according to the fourth aspect, reference may be made to the technical effects of the method according to either of the first aspect and the second aspect. Details are not described herein again.

According to a fifth aspect, a communication apparatus is provided. The communication apparatus includes a processor. The processor is coupled to a memory. The processor is configured to execute a computer program stored in the memory, to enable the communication apparatus to perform the method according to either of the first aspect and the second aspect.

In a possible design solution, the communication apparatus according to the fifth aspect may further include a transceiver. The transceiver may be a transceiver circuit or an interface circuit. The transceiver may be used by the communication apparatus according to the fifth aspect to communicate with another communication apparatus.

In embodiments of this application, the communication apparatus according to the fifth aspect may be the terminal or the network device according to either of the first aspect and the second aspect, a chip (system) or another component or assembly that may be disposed in the terminal or the network device, or an apparatus that includes the terminal or the network device.

In addition, for technical effects of the communication apparatus according to the fifth aspect, reference may be made to the technical effects of the method according to the first aspect. Details are not described herein again.

According to a sixth aspect, a communication apparatus is provided, including a processor and a memory. The memory is configured to store a computer program, and when the processor executes the computer program, the communication apparatus is enabled to perform the method according to either of the first aspect and the second aspect.

In a possible design solution, the communication apparatus according to the sixth aspect may further include a transceiver. The transceiver may be a transceiver circuit or an interface circuit. The transceiver may be used by the communication apparatus according to the sixth aspect to communicate with another communication apparatus.

In embodiments of this application, the communication apparatus according to the sixth aspect may be the terminal or the network device according to either of the first aspect and the second aspect, a chip (system) or another component or assembly that may be disposed in the terminal or the network device, or an apparatus that includes the terminal or the network device.

In addition, for technical effects of the communication apparatus according to the sixth aspect, reference may be made to the technical effects of the method according to either of the first aspect and the second aspect. Details are not described herein again.

According to a seventh aspect, a communication system is provided. The communication system includes a first communication apparatus configured to perform the method according to the first aspect and a second communication apparatus configured to perform the method according to the second aspect.

According to an eighth aspect, a computer-readable storage medium is provided, including a computer program or instructions. When the computer program or the instructions are run on a computer, the computer is enabled to perform the method according to either of the first aspect and the second aspect.

According to a ninth aspect, a computer program product is provided, including a computer program or instructions. When the computer program or the instructions are run on a computer, the computer is enabled to perform the method according to either of the first aspect and the second aspect.

### BRIEF DESCRIPTION OF DRAWINGS

FIG. 1 is a diagram of encoding of an 8*8 polar code;
FIG. 2 is a diagram 1 of a polar code framework according to an embodiment of this application;
FIG. 3 is a diagram 2 of a polar code framework according to an embodiment of this application;
FIG. 4 is a diagram 3 of a polar code framework according to an embodiment of this application;
FIG. 5 is a diagram 1 of an architecture of a communication system according to an embodiment of this application;
FIG. 6 is a diagram 2 of an architecture of a communication system according to an embodiment of this application;
FIG. 7 is a diagram of a polar code encoding process according to an embodiment of this application;
FIG. 8 is a schematic flowchart of a polar-code coding method according to an embodiment of this application;
FIG. 9 is a diagram 1 of an application scenario of a polar-code coding method according to an embodiment of this application;
FIG. 10 is a diagram 2 of an application scenario of a polar-code coding method according to an embodiment of this application;
FIG. 11 is a diagram 1 of a structure of a communication apparatus according to an embodiment of this application; and
FIG. 12 is a diagram 2 of a structure of a communication apparatus according to an embodiment of this application.

### DESCRIPTION OF EMBODIMENTS

For ease of understanding, the following first describes technical terms in embodiments of this application.

### 1. Polar (polar) code

The polar code is the first channel coding scheme that can be rigorously proved to "achieve" Shannon channel capacity, offering both excellent error-correction performance and low-complexity decoding. Currently, the polar code has been determined by the 3rd Generation Partnership Project (3rd generation partnership project, 3GPP) as an uplink/downlink control channel coding scheme in 5th generation (5th generation, 5G) enhanced mobile broadband (enhanced mobile broadband, eMBB) scenarios.

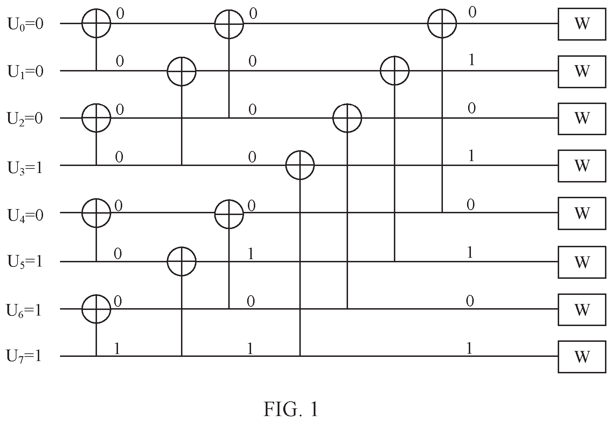

FIG. 1 is a diagram of encoding of an 8*8 polar code. As shown in FIG. 1, "+" represents an exclusive OR operation, and to-be-encoded bits are arranged based on reliability of corresponding bit subchannels. Generally, a bit (bit) with higher reliability is set as an information bit (data) position, and an information bit is carried during actual transmission. For example, *u*₇, *u*₆, *u*₅, and *u*₃ are four bits with higher reliability, and are set as information bits. A bit with lower reliability is set as a frozen (frozen) bit. For example, *u*₄, *u*₂, *u*₁, and *u*₀ are four bits with lower reliability, and are set as frozen bits. A value of the frozen bit is usually set to 0, and is known to both a transmitter side and a receiver side during actual transmission.

In recent years, with the inclusion of polar code in 5G standards, research on polar code decoding has become a hot issue in the communication field. Currently, based on a decoding timing of a polar code decoding method, mainstream polar code decoding methods may be classified into two types: sequential decoding and non-sequential decoding. The sequential decoding means that a decoder performs decoding based on a natural time sequence designed for the polar code. The non-sequential decoding means that a decoder outputs decoding results in parallel based on another structure (for example, a Tanner graph or a Trellis graph) of the polar code. Currently, main polar code sequential decoding algorithms include successive cancellation (successive cancellation, SC) decoding, successive cancellation list (successive cancellation list, SCL) decoding, successive cancellation stack (successive cancellation stack, SCS) decoding, cyclic redundancy check-aided SCL (cyclic redundancy check-aided successive cancellation list, CA-SCL) decoding, and the like. Non-sequential decoding methods mainly include (belief propagation, BP) decoding and the like. In terms of decoding performance, the SC decoding has worst performance, and the SCL decoding achieves great improvement over the SC decoding. CA-SCL with a CRC check can make performance of a polar code better than that of low-density parity check code (low density parity check code, LDPC) and Turbo code. Therefore, currently, the SCL decoding and the CA-SCL decoding are mainly used in an actual system.

The following separately describes two scenarios: hybrid automatic repeat request transmission of a polar code and a polar code supporting self-decoding.

### 2. Hybrid automatic repeat request

Hybrid automatic repeat request (hybrid automatic repeat request, HARQ) is a general technology in wireless communication. HARQ is classified into chase-combining (chase combine, CC) HARQ and incremental redundancy (incremental redundancy, IR)-HARQ. In HARQ, combined use of forward error correction (forward error correction, FEC) and automatic repeat-request (automatic repeat-reQuest, ARQ) methods can significantly improve spectral efficiency.

Basic operating procedures of HARQ are as follows: First, a transmitter side sends an encoded packet for initial transmission, and a receiver side receives a symbol sequence and attempts to perform decoding. If the decoding succeeds, the receiver side sends feedback information indicating successful reception (Acknowledgement, ACK), prompting the transmitter side to stop sending. If the decoding fails, the receiver side buffers the received symbol sequence (or corresponding demodulation soft information), and sends feedback information indicating unsuccessful reception (Negative Acknowledgement, NACK), or does not feed back any signal. If the transmitter side receives the feedback information NACK (or does not receive an ACK signal), the transmitter side continues to send a re-encoded bit sequence (as incremental redundancy). The receiver side performs joint decoding based on sequences received twice.

In comparison with transmitting, at one time, all data that is sent a plurality of times in HARQ transmission, HARQ allows for stopping transmission when the decoding succeeds midway, so that a system throughput can be improved. If the initial transmission succeeds, retransmission is not required. This is equivalent to reducing spectrum resources, that is, improving spectral efficiency. If the initial transmission fails, the receiver side performs joint decoding on data received twice. This can still achieve long code correction performance.

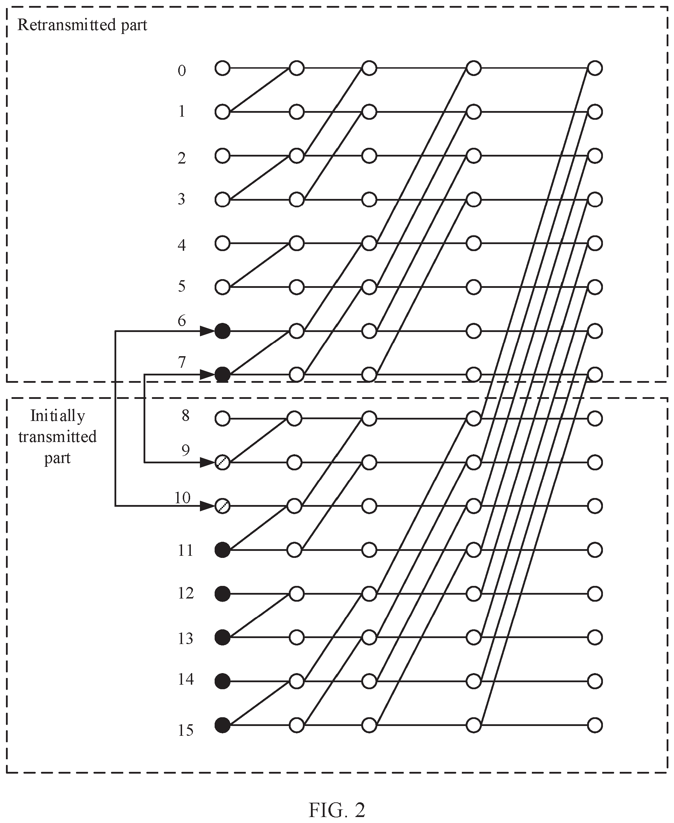

FIG. 2 shows a polar code-based IR-HARQ solution. A lower half part {8, 9, 10, 11, 12, 13, 14, 15} (denoted as a U code) of a trellis graph corresponds to the initial transmission, an upper half part {0, 1, 2, 3, 4, 5, 6, 7} (denoted as a V code) corresponds to retransmission, and lengths of the U code and the V code are both 8. From a leftmost side of the trellis graph, blank-filled nodes {0, 1, 2, 3, 4, 5, 8} represent frozen bit positions, black-filled nodes {6, 7, 11, 12, 13, 14, 15} represent information bit positions, and shadow-filled nodes {8, 9} and black-filled nodes {6, 7} connected to the shadow-filled nodes {8, 9} have same information bit values. If the U code is separately decoded during decoding, a black-filled bit position and a shadow-filled bit position are information bit positions. In other words, {9, 10, 11, 12, 13, 14, 15} are information bit positions. If the U code and the V code are jointly decoded, the initial transmission and the retransmission may be combined into a polar code with a length of 16. The black-filled bit position part {6, 7, 11, 12, 13, 14, 15} is the information bit. When the shadow-filled bit positions {8, 9} are decoded, a result of the shadow-filled bit positions {8, 9} is obtained by decoding the black-filled bit positions {6, 7} that have the same result. Therefore, the shadow-filled bit positions {8, 9} become known values, and may be understood as dynamic frozen bit positions.

Within this framework, regardless of whether the U code is separately decoded or the U code and the V code are jointly decoded, the information bit position is always carried at a highly reliable position, to ensure optimal decoding performance.

### 3. Construction of a polar code supporting self-decoding

Directly sending a plurality of redundancy versions (redundancy versions, RVs) is a common coverage enhancement method in wireless communication. Each RV may be understood as a code. Generally, each RV version supports independent decoding, and a plurality of RV versions may be combined as a long code to enhance decoding. Compared with separately sending one long code, multi-RV transmission allows a receiver side to still have a capability of performing decoding based on a remaining RV when a specific RV is completely lost, but directly sending one long code does not have this capability.

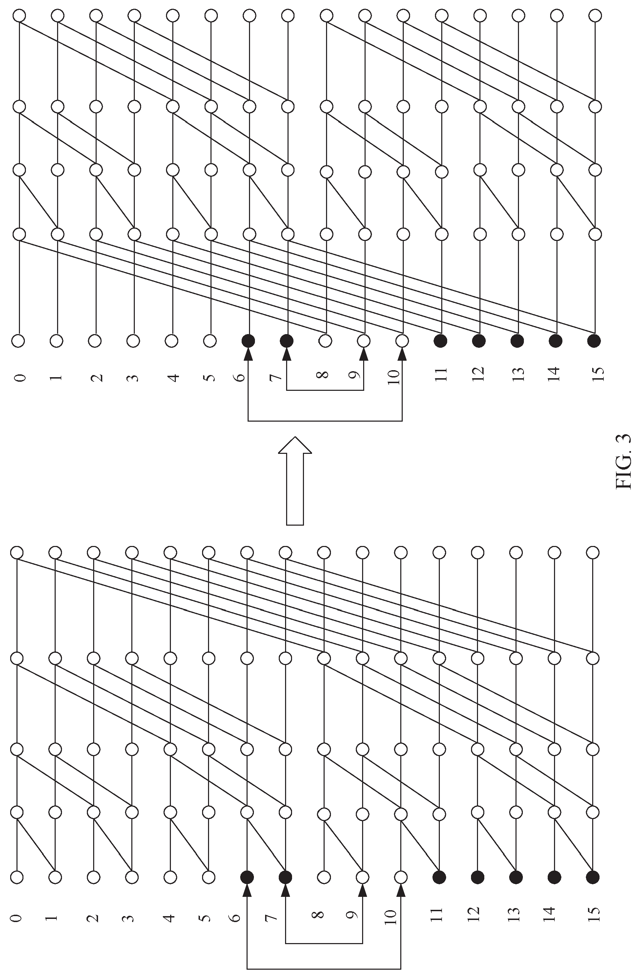

The polar code is code that inherently supports a self-decoding requirement. As shown in FIG. 3, a diagram of a common polar code is shown on a left side, and a right-side trellis graph may be obtained through inter-stage interleaving. It can be learned that, when there is a one-to-one mapping relationship between a U code {8, 9, 10, 11, 12, 13, 14, 15} and a V code {0, 1, 2, 3, 4, 5, 6, 7}, the U code or the V code each includes complete information of an information bit. If the U code or the V code is separately received, when a channel condition is good, a decoder may separately perform decoding based on the U code or the V code.

As described above, a construction process of polar self-decoding is similar to that of IR-HARQ.

### 4. Construction of a polar code

The construction of the polar code means determining an information bit position and a frozen bit position of the polar code. In a current new radio (new radio, NR) standard, construction of the polar code is determined based on a reliability sequence. For example, a reliability sequence {0, 1, 2, 4, 8, 3, 5, 9, 6, 10, 12, 7, 11, 13, 14, 15} with a length of 16 is pre-stored, and the sequence represents that a most reliable information bit position is 15, followed by 14, ..., with an information bit position 0 being the least reliable.

When a polar code present when K=8 is constructed, {15, 14, 13, 11, 7, 12, 10, 6} are read from back to front based on the reliability sequence as information bit positions, and another position are used as a frozen bit position. However, in wireless communication, a very flexible code length and code rate are usually required. In addition to a code with a length of 16, a code with a length of 32, a length of 64, ..., or a length of 1024 also needs to be constructed. If one sequence is stored for each length, storage overheads are excessively high.

For this problem, in a conventional technology, a sequence with a length of 1024 is pre-stored, and then subsequences with different lengths are obtained through nested extraction, to construct a shorter code. Specifically, when a code with a length of N needs to be constructed, sequence numbers less than N in the pre-stored sequence are extracted to form a subsequence, to determine the information bit position.

From a perspective of an IR-HARQ equivalent long code, a V-code reliability sequence is actually used to construct an information bit position of a U code in the foregoing process. Because a U-code reliability sequence is not completely the same as the V-code reliability sequence, additional complexity overheads are caused to a polar code construction process.

For further description, a pre-stored sequence {0, 1, 2, 4, 8, 3, 5, 9, 6, 10, 12, 7, 11, 13, 14, 15} whose length is 16 and that is arranged based on reliability is used as an example. In IR-HARQ, both lengths of initial transmission and retransmission are 8, and a quantity of information bits is denoted as K. The initial transmission is constructed by using a sequence of 0 to 7, and K positions are selected as an information bit position set ${\overline{Q}}_{{I}_{1}}^{8}$ based on the sequence. If decoding during the initial transmission fails, K positions are further selected based on the sequence with the length of 16 to be used as an information bit position set ${\overline{Q}}_{{I}_{2}}^{16}$. Further, sets ${\overline{Q}}_{cp}^{u}$ (a shadow-filled bit position) and ${\overline{Q}}_{cp}^{v}$ (a black-filled bit position corresponding to the shadow-filled bit position) are further determined based on ${\overline{Q}}_{{I}_{2}}^{16}$ and ${\overline{Q}}_{{I}_{1}}^{8}$, and a one-to-one check relationship is formed between ${\overline{Q}}_{cp}^{u}$ and ${\overline{Q}}_{cp}^{v}$.

If the U-code reliability sequence is completely the same as the V-code reliability sequence, the U-code reliability sequence may be directly constructed according to the following simple method. ${\overline{Q}}_{cp}^{v}$ is a subset including an element less than 8 in ${\overline{Q}}_{{I}_{2}}^{16} , { \overline{Q}}_{cp}^{u}$ is a set ${\overline{Q}}_{{I}_{1}}^{16} - {\overline{Q}}_{{I}_{2}}^{16}$, and ${\overline{Q}}_{{I}_{1}}^{16}$ is obtained by adding 8 to each element in ${\overline{Q}}_{{I}_{1}}^{8}$.

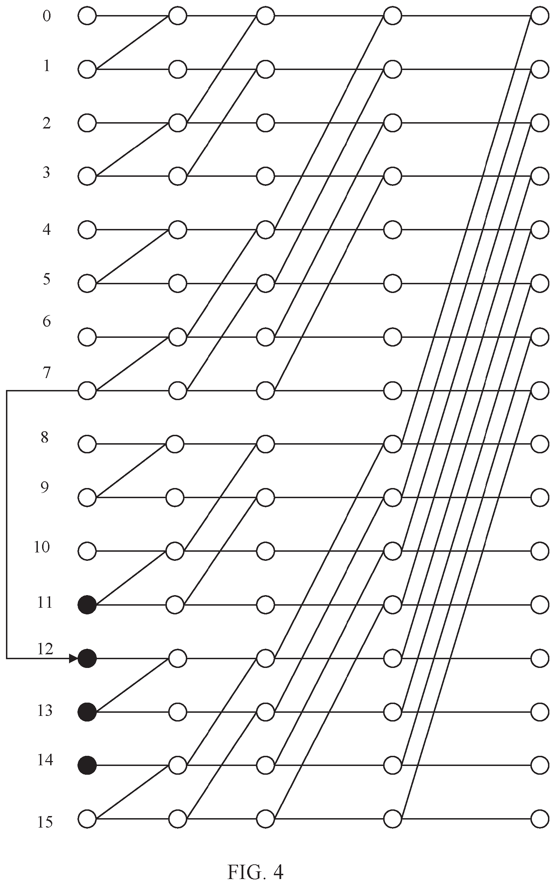

Because the U-code reliability sequence is not completely the same as the V-code reliability sequence, there may be a case in which a node is not selected as an information bit position during initial transmission, but the node is selected as an information bit position during retransmission. For example, as shown in FIG. 4, ${\overline{Q}}_{{I}_{1}}^{8} = \left\{3, 4, 5, 6\right\}$. In this case, ${\overline{Q}}_{{I}_{1}}^{16} = \left\{11, 12, 13, 14\right\}$ (corresponding to black-filled nodes in FIG. 4), and ${\overline{Q}}_{{I}_{2}}^{16} = \left\{7, 13, 14, 15\right\}$. However, because {11, 12, 13, 14} has actually been used as information bit positions when a U code is initially transmitted, if the foregoing method is used, ${\overline{Q}}_{cp}^{v}$ is a subset {7} including the element less than 8 in ${\overline{Q}}_{{I}_{2}}^{16} , { \overline{Q}}_{cp}^{u}$ is a set ${\overline{Q}}_{{I}_{1}}^{16} - {\overline{Q}}_{{I}_{2}}^{16} = \left\{11, 12\right\}$, quantities in ${\overline{Q}}_{cp}^{v}$ and ${\overline{Q}}_{cp}^{u}$ that are obtained through calculation are different, and cannot be in a one-to-one correspondence with each other, and it should be further determined, based on a reliability order, that {12} with low reliability is ${\overline{Q}}_{cp}^{u}$, and ${\overline{Q}}_{cp}^{v} = \left\{7\right\}$. It is difficult to quickly obtain the two sets ${\overline{Q}}_{cp}^{v}$ and ${\overline{Q}}_{cp}^{u}$ according to a unified principle. This increases construction complexity.

For the foregoing technical problems, embodiments of this application provide the following technical solutions.

The following describes the technical solutions of this application with reference to accompanying drawings.

The technical solutions in embodiments of this application may be applied to various communication systems, for example, a wireless network (Wi-Fi) system, a vehicle-to-everything (vehicle-to-everything, V2X) communication system, a device-to-device (device-to-device, D2D) communication system, an internet of vehicles communication system, a 4th generation (4th generation, 4G) mobile communication system such as a long term evolution (long term evolution, LTE) system, a worldwide interoperability for microwave access (worldwide interoperability for microwave access, WiMAX) communication system, a 5th generation (5th generation, 5G) system such as a new radio (new radio, NR) system, and a future communication system.

In embodiments of this application, "indicate" may include a direct indication and an indirect indication, or may include an explicit indication and an implicit indication. Information indicated by specific information (for example, the following first indication information, second indication information, or third indication information) is referred to as to-be-indicated information. In a specific implementation process, the to-be-indicated information is indicated in a plurality of manners, for example, but not limited to, the to-be-indicated information, for example, the to-be-indicated information or an index of the to-be-indicated information, may be directly indicated. Alternatively, the to-be-indicated information may be indirectly indicated by indicating other information, and there is an association relationship between the other information and the to-be-indicated information. Alternatively, only a part of the to-be-indicated information may be indicated, and the other part of the to-be-indicated information is known or pre-agreed on. For example, specific information may alternatively be indicated based on an arrangement order that is of a plurality of pieces of information and that is pre-agreed on (for example, specified in a protocol), to reduce indication overheads to some extent. In addition, a common part of all pieces of information may be identified and indicated in a unified manner, to reduce indication overheads caused by separately indicating same information.

Moreover, specific indication manners may alternatively be various existing indication manners, for example, but not limited to, the foregoing indication manners and various combinations thereof. For details of the various indication manners, refer to the conventional technology. Details are not described in this specification again. It can be learned from the foregoing descriptions that, for example, when a plurality of pieces of information of a same type need to be indicated, different information may be indicated in different manners. In a specific implementation process, a required indication manner may be selected according to a specific requirement. The selected indication manner is not limited in embodiments of this application. In this way, the indication manner in embodiments of this application should be understood as covering various methods that can enable a to-be-indicated party to learn of the to-be-indicated information.

It should be understood that the to-be-indicated information may be sent as a whole, or may be divided into a plurality of pieces of sub-information for separate sending. In addition, sending periodicities and/or sending occasions of these pieces of sub-information may be the same or may be different. A specific sending method is not limited in embodiments of this application. The sending periodicities and/or the sending occasions of these pieces of sub-information may be predefined, for example, predefined according to a protocol, or may be configured by a transmitter device by sending configuration information to a receiver device.

"Predefinition" or "pre-configuration" may be implemented by pre-storing corresponding code or a corresponding table in a device, or may be implemented in another manner that may indicate related information. A specific implementation thereof is not limited in embodiments of this application. "Storage" may be storage in one or more memories. The one or more memories may be separately disposed, or may be integrated into an encoder, a decoder, a processor, or a communication apparatus. Alternatively, a part of the one or more memories may be separately disposed, and a part of the one or more memories are integrated into a decoder, a processor, or a communication apparatus. A type of the memory may be a storage medium in any form. This is not limited in embodiments in this application.

The "protocol" in embodiments of this application may be a protocol family in the communication field, a standard protocol with a frame structure similar to that of the protocol family, or a related protocol applied to a future communication system. This is not specifically limited in embodiments of this application.

In embodiments of this application, descriptions such as "when ...", "in a case of ...", and "if" all mean that a device performs corresponding processing in an objective case, and do not limit time, and the device is not required to perform a determining action during implementation. This does not mean that there is another limitation.

In descriptions of embodiments of this application, unless otherwise stated, "/" means an "or" relationship between associated objects. For example, A/B may indicate A or B. In embodiments of this application, "and/or" describes only an association relationship between associated objects, and indicates that three relationships may exist. For example, A and/or B may represent three cases: Only A exists, both A and B exist, and only B exists, where A and B may be singular or plural. In addition, in the descriptions of embodiments of this application, unless otherwise specified, "a plurality of" means two or more. "At least one of the following items (pieces)" or a similar expression thereof means any combination of these items, including a singular item (piece) or any combination of plural items (pieces). For example, at least one of a, b, or c may indicate a, b, c, a and b, a and c, b and c, or a, b, and c, where a, b, and c may be singular or plural. In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, terms such as "example" or "for example" indicates giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

A network architecture and a service scenario described in embodiments of this application are intended to describe the technical solutions in embodiments of this application more clearly, and do not constitute a limitation on the technical solutions provided in embodiments of this application. A person of ordinary skill in the art may learn that, with evolution of the network architecture and emergence of new service scenarios, the technical solutions provided in embodiments of this application are also applicable to similar technical problems.

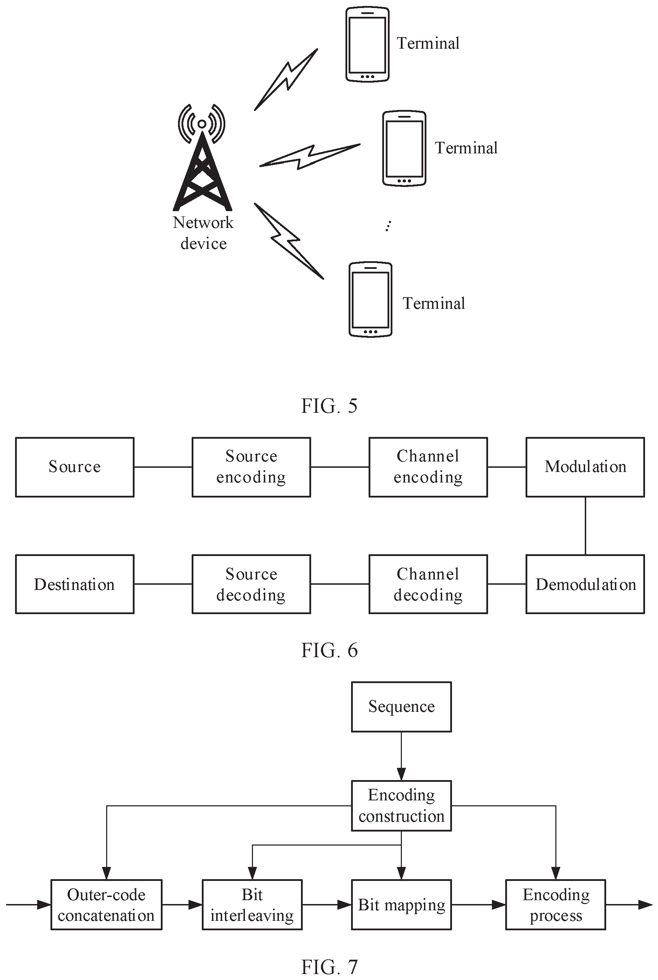

For ease of understanding of embodiments of this application, a communication system shown in FIG. 5 is first used as an example to describe in detail a communication system to which embodiments of this application are applicable. For example, FIG. 5 is a diagram of an architecture of a communication system to which a method according to an embodiment of this application is applicable.

As shown in FIG. 5, the communication system may include a first communication apparatus and a second communication apparatus.

The communication apparatus may be a terminal or a network device.

The terminal may also be referred to as user equipment (user equipment, UE), an access terminal, a subscriber unit (subscriber unit), a subscriber station, a mobile station (mobile station, MS), a remote station, a remote terminal, a mobile device, a user terminal, a terminal, a wireless communication device, a user agent, or a user apparatus. The terminal in embodiments of this application may be a mobile phone (mobile phone), a cellular phone (cellular phone), a smartphone (smartphone), a tablet computer (Pad), a wireless data card, a personal digital assistant (personal digital assistant, PDA) computer, a wireless modem (modem), a handheld device (handset), a laptop computer (laptop computer), a machine type communication (machine type communication, MTC) terminal, a computer with a wireless transceiver function, a virtual reality (virtual reality, VR) terminal, an augmented reality (augmented reality, AR) terminal, a smart home device (for example, a refrigerator, a television, an air conditioner, or an electricity meter), a smart robot, a robot arm, a workshop device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), a vehicle-mounted terminal, a roadside unit (roadside unit, RSU) or the like with a terminal function, a flight device (for example, a smart robot, a hot air balloon, an uncrewed aerial vehicle, or an aircraft), or the like. The terminal in this application may alternatively be a vehicle-mounted module, a vehicle-mounted assembly, a vehicle-mounted component, a vehicle-mounted chip, or a vehicle-mounted unit that is disposed in a vehicle as one or more components or units. The terminal device may alternatively be another device with a function of a terminal. For example, the terminal device may alternatively be a device that functions as a terminal in D2D communication.

A device form of the terminal is not limited in embodiments of this application. An apparatus configured to implement a function of the terminal may be a terminal, or may be an apparatus, for example, a chip system, that can support the terminal in implementing the function. The apparatus may be mounted in the terminal, or may match the terminal for use. In embodiments of this application, the chip system may include a chip, or may include a chip and another discrete component.

The network device may be a radio access network (radio access network, RAN) device, and is also referred to as an access network apparatus. The access network apparatus may be specifically a next-generation mobile communication system, for example, a 6G access network device, for example, a 6G base station. Alternatively, in the next-generation mobile communication system, the access network apparatus may be named in another manner, and all naming manners fall within the protection scope of embodiments of this application. This is not limited in this application. Alternatively, the access network apparatus may include a gNB in 5G, for example, a new radio (new radio, NR) system, may include one or a group of antenna panels (including a plurality of antenna panels) of a base station in 5G, or may be a network node that forms a gNB, a transmission and reception point (transmission and reception point, TRP, or transmission point, TP), or a transmission measurement function (transmission measurement function, TMF), for example, a central unit (central unit, CU), a distributed unit (distributed unit, DU), a CU-control plane (control plane, CP), or a CU-user plane (user plane, UP), a radio unit (radio unit, RU), an RSU with a base station function, a wired access gateway, or a 5G core network element. Alternatively, the access network apparatus may further include an access point (access point, AP) in a wireless fidelity (wireless fidelity, Wi-Fi) system, a wireless relay node, a wireless backhaul node, various forms of macro base stations, a micro base station (also referred to as a small cell), a relay station, an access point, a wearable device, a vehicle-mounted device, or the like.

The CU and the DU may be separately disposed, or may be included in a same network element, for example, a baseband unit (baseband unit, BBU). The RU may be included in a radio frequency device or a radio frequency unit, for example, a remote radio unit (remote radio unit, RRU), an active antenna unit (active antenna unit, AAU), or a remote radio head (remote radio head, RRH). It may be understood that the network device may be a CU node, a DU node, or a device including a CU node and a DU node. In addition, the CU may be classified as a network device in an access network RAN, or the CU may be classified as a network device in a core network CN. This is not limited herein.

In different systems, the CU (or the CU-CP and the CU-UP), the DU, or the RU may also have different names, but a person skilled in the art may understand meanings thereof. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any unit of the CU (or the CU-CP or the CU-UP), the DU, and the RU in this application may be implemented by using a software module, a hardware module, or a combination of a software module and a hardware module.

The communication system in embodiments of this application is applicable to a coding scenario, and may be implemented by using a dedicated chip ASIC or a programmable chip FPGA, or may be implemented by using software (program code in a memory). As shown in FIG. 6, coding mainly involves source encoding, channel encoding, channel decoding, and source recovery parts. For a specific principle, refer to a related technology in 3GPP. FIG. 7 shows polar code encoding procedures, involving a sequence obtaining process, encoding construction process, outer-code concatenation process, bit interleaving process, bit mapping process, and encoding process. A core innovation point in embodiments of this application mainly relates to sequence obtaining.

In the communication system, the first communication apparatus performs nested extraction on a sequence number whose value is greater than or equal to (M-N) from a first sequence, to obtain a first subset including sequence numbers of N channels, determines a second sequence with a length of N based on the first subset, and further performs polar encoding based on the second sequence. In this way, there is no need to store one sequence for each length. A latter portion of the first sequence is extracted, so that subsequences with different lengths may be obtained through nested extraction to construct a codeword. This increases nested extraction flexibility, and reduces polar code construction complexity.

A device form of the network device is not limited in embodiments of this application. An apparatus configured to implement a function of the network device may be the network device, or may be an apparatus that can support the network device in implementing the function, for example, a chip system. The apparatus may be mounted in the network device or used in cooperation with the network device. In embodiments of this application, the chip system may include a chip, or may include a chip and another discrete component.

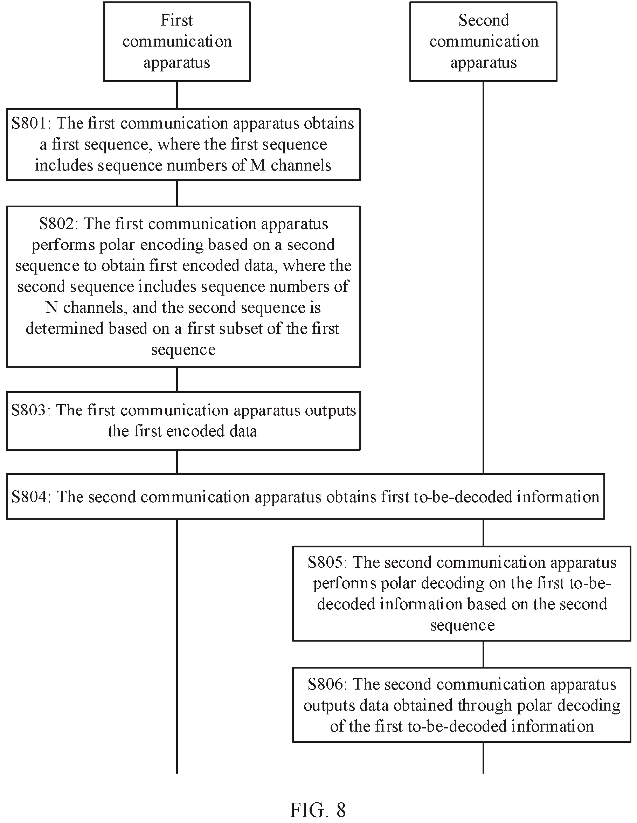

With reference to FIG. 8 to FIG. 10, the following specifically describes interaction procedures between network elements/devices in the foregoing communication system by using method embodiments. The polar-code coding method provided in embodiments of this application is applicable to the foregoing communication system, and is specifically applied to various scenarios/procedures mentioned in the foregoing communication system. The following provides specific descriptions.

FIG. 8 is a schematic flowchart of a polar-code coding method according to an embodiment of this application. The polar-code coding method is applicable to the foregoing communication system, and mainly relates to interaction between a first communication apparatus and a second communication apparatus.

As shown in FIG. 8, procedures of the polar-code coding method are as follows.

S801: The first communication apparatus obtains a first sequence.

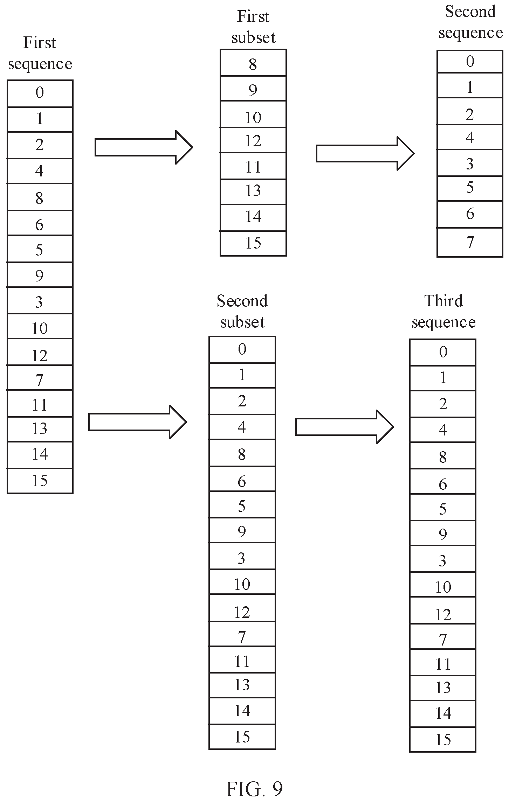

The first sequence may include sequence numbers of M channels. In other words, a length of the first sequence may be M, where M is an integer greater than or equal to 0. The sequence numbers of the M channels are arranged in the first sequence in ascending order of channel reliability. For example, as shown in FIG. 9, the first communication apparatus obtains a first sequence with a length of 16. Sequence numbers of 16 channels in the first sequence are arranged in ascending order of the channel reliability as {0, 1, 2, 4, 8, 6, 5, 9, 3, 10, 12, 7, 11, 13, 14, 15}. The sequence represents that a most reliable information bit position is 15, followed by 14, ..., with an information bit position 0 being the least reliable.

The first sequence may be a pre-stored sequence that can be directly obtained, or may be data transmitted through a wireless air interface. There are a plurality of manners in which the first communication apparatus obtains the first sequence. For example, the first sequence may be obtained based on a trigger condition (for example, a service needs to be established, and service data needs to be transmitted). For another example, the first sequence may be obtained according to a protocol definition. This is not specifically limited herein.

S802: The first communication apparatus performs polar encoding based on a second sequence, to obtain first encoded data.

The second sequence may include sequence numbers of N channels. In other words, a length of the second sequence may be N, where N is an integer greater than or equal to 0. The first communication apparatus obtains, from the first sequence, a first subset in which a value of the sequence number is greater than or equal to (M-N), and a length of the obtained first subset is N. In other words, the first subset includes N sequence numbers. For example, M is 16, and N is 4. In this case, when obtaining the second sequence with a length of 4, the first communication apparatus may extract, from the first sequence with a length of 16, the first subset in which the value of the sequence number is greater than or equal to (M-N)=12. Then, the second sequence is determined based on the first subset.

In addition, the first sequence may be the first subset of the first sequence. In other words, N is less than or equal to M.

Optionally, before performing polar encoding based on the second sequence to obtain the first encoded data, the polar-code coding method may further include: obtaining control signaling. Determining control signaling indicates to extract a sequence in a target extraction manner, and the target extraction manner includes the method provided in this embodiment of this application.

It may be understood that whether the control signaling indicates that a sequence extraction manner is the target extraction manner may be first determined based on information, for example, a user scenario, whether HARQ is activated, a decoding capability of a receiver decoder, and 5G or 6G, that is included in the control signaling. For example, if the control signaling includes information about activating the HARQ, it indicates that the sequence extraction manner is the target extraction manner. If the sequence extraction manner is the target extraction manner, the second sequence is extracted based on the method provided in this embodiment of this application. If the sequence extraction manner is another extraction manner, an extraction manner in the conventional technology is still used, or a manner newly defined in the future is used. In this way, sequence reading flexibility can be increased, and compatibility with the NR standard is facilitated.

Optionally, that the second sequence is determined based on the first subset of the first sequence may include: The second sequence is the first subset of the first sequence; or the second sequence is the same as a sequence obtained by subtracting (M-N) from a value of each sequence number in the first subset of the first sequence.

It may be understood that the first subset may be a subsequence of the first sequence. The first communication apparatus may directly extract the first subset from the first sequence as the second sequence, or may obtain the second sequence by subtracting (M-N) from a value of each sequence number in the first subset. For example, as shown in FIG. 9, the first communication apparatus extracts, from the first sequence {0, 1, 2, 4, 8, 6, 5, 9, 3, 10, 12, 7, 11, 13, 14, 15}, a first subset in which the value of the sequence number is greater than or equal to 8, where the first subset is {8, 9, 10, 12, 11, 13, 14, 15}, and directly determines the first subset as the second sequence. Alternatively, the first communication apparatus subtracts 8 from the value of each sequence number in the first subset, to obtain a subsequence {0, 1, 2, 4, 3, 5, 6, 7}, and determines the subsequence as the second sequence. In this way, flexibility of performing nested extraction on a sequence is increased.

S803: The first communication apparatus outputs the first encoded data.

In some embodiments, the first communication apparatus performs, corresponding to data retransmission, polar encoding based on a third sequence to obtain second encoded data.

When initial transmission fails, the first communication apparatus performs data retransmission.

The third sequence may include sequence numbers of N1 channels. In other words, a length of the third sequence may be N1, where N1 is an integer greater than or equal to 0, and N is less than or equal to N1. The first communication apparatus obtains a second subset with a length of N1 from the first sequence. In other words, the second subset includes N1 sequence numbers. In addition, the first sequence may be the second subset of the first sequence. In other words, N1 is less than or equal to M.

The third sequence is determined based on the second subset, and the third sequence corresponds to the second sequence. This can ensure that an information bit position selected during the data retransmission is a subset of an information bit position selected during the initial data transmission, and avoid a case in which an information bit position that is not selected during the initial data transmission is selected as an information bit position during the data retransmission. This simplifies implementation of a decoder during the data retransmission, and can adapt to a requirement of IR-HARQ.

In addition, lengths of the first sequence, the second sequence, and the third sequence each may be an integer power of 2.

Optionally, that the third sequence is determined based on the second subset of the first sequence may include: The third sequence is the second subset of the first sequence; or the third sequence is the same as a sequence obtained by subtracting (M-N1) from a value of each sequence number in the second subset of the first sequence.

It may be understood that the second subset may be a subsequence of the first sequence. The first communication apparatus may directly extract the second subset from the first sequence as the third sequence, or may obtain the third sequence by subtracting (M-N) from the value of each sequence number in the second subset, thereby increasing nested extraction flexibility. A process of determining the third sequence based on the second subset may be the same as that of determining the second sequence based on the first subset.

When the second sequence is the first subset, and the third sequence is the second subset, that the third sequence corresponds to the second sequence is: An order, in the third sequence, of values that are of sequence numbers in the third sequence and that are greater than or equal to M-N is the same as an order, in the second sequence, of values of sequence numbers included in the second sequence.

For example, M=64, N=16, N1=32, and a first sequence with a length of 64 is:
{0, 1, 2, 4, 8, 16, 32, 3, 5, 9, 6, 17, 10, 18, 12, 33, 20, 34, 24, 36, 7, 11, 40, 19, 13, 48, 14, 21, 35, 26, 37, 25, 22, 38, 41, 28, 42, 49, 44, 50, 15, 52, 23, 56, 27, 39, 29, 43, 30, 45, 51, 46, 53, 54, 57, 58, 60, 31, 47, 55, 59, 61, 62, 63}.

A first subset {48, 49, 50, 52, 56, 51, 53, 54, 57, 58, 60, 55, 59, 61, 62, 63} is extracted from the first sequence, the first subset is used as a second sequence, a second subset is extracted from the first sequence, and the second subset is used as a third sequence. The third sequence is {32, 33, 34, 36, 40, 48, 35, 37, 38, 41, 42, 49, 44, 50, 52, 56, 39, 43, 45, 51, 46, 53, 54, 57, 58, 60, 47, 55, 59, 61, 62, 63}. In other words, a sequence number, whose value is greater than or equal to 48, in the third sequence corresponds to that in the second sequence.

When the second sequence is obtained by subtracting M-N from the value of each sequence number in the first subset, and the third sequence is the second subset, that the third sequence corresponds to the second sequence is: An order, in the third sequence, of values that are of the sequence numbers in the third sequence and that are greater than or equal to M-N is the same as an order, in the second sequence, of values of all sequence numbers in the second sequence plus M-N.

For ease of understanding, the foregoing example is further described.

If the second sequence is obtained by subtracting 48 from the value of each sequence number in the first subset of the first sequence, that is, the second sequence is {0, 1, 2, 4, 8, 3, 5, 6, 9, 10, 12, 7, 11, 13, 14, 15}, and the third sequence is the second subset of the first sequence, that is, the third sequence is {32, 33, 34, 36, 40, 48, 35, 37, 38, 41, 42, 49, 44, 50, 52, 56, 39, 43, 45, 51, 46, 53, 54, 57, 58, 60, 47, 55, 59, 61, 62, 63}, a sequence number, whose value is greater than or equal to 48, in the third sequence corresponds to the value of each sequence number in the second sequence plus 48.

When the second sequence is obtained by subtracting M-N from the value of each sequence number in the first subset, and the third sequence is obtained by subtracting M-N from the value of each sequence number in the second subset, that the third sequence corresponds to the second sequence is: An order, in the third sequence, of values that are of the sequence numbers in the third sequence and that are greater than or equal to N1-N is the same as an order, in the second sequence, of the values of all sequence numbers in the second sequence plus N1-N.

For ease of understanding, the foregoing example is further described.

If the second sequence is obtained by subtracting 48 from the value of each sequence number in the first subset of the first sequence, that is, the second sequence is {0, 1, 2, 4, 8, 3, 5, 6, 9, 10, 12, 7, 11, 13, 14, 15}, and the third sequence is obtained by subtracting 48 from the value of each sequence number in the second subset of the first sequence, that is, {0, 1, 2, 4, 8, 16, 3, 5, 6, 9, 10, 17, 12, 18, 20, 24, 7, 11, 13, 19, 14, 21, 22, 25, 26, 28, 15, 23, 27, 29, 30, 31}, a sequence number, whose value is greater than or equal to 16, in the third sequence corresponds to the value of each sequence number in the second sequence plus 16.

When the second sequence is the first subset, and the third sequence is obtained by subtracting M-N from the value of each sequence number in the second subset, that the third sequence corresponds to the second sequence is: An order, in the third sequence, of sequence numbers that are in the third sequence and that are greater than or equal to N1-N is the same as an order, in the second sequence, of values that are of the sequence numbers in the second sequence and that are obtained by subtracting M-N1 from the values of the sequence numbers.

For ease of understanding, the foregoing example is further described.

If the second sequence is the first subset of the first sequence, namely, {48, 49, 50, 52, 56, 51, 53, 54, 57, 58, 60, 55, 59, 61, 62, 63}, and the third sequence may be obtained by subtracting 48 from the value of each sequence number in the second subset of the first sequence, that is, the third sequence may be {0, 1, 2, 4, 8, 16, 3, 5, 6, 9, 10, 17, 12, 18, 20, 24, 7, 11, 13, 19, 14, 21, 22, 25, 26, 28, 15, 23, 27, 29, 30, 31}, a sequence number, whose value is greater than or equal to 16, in the third sequence corresponds to the value of each sequence number in the second sequence minus 32.

In this way, it can be ensured that the second sequence corresponds to a latter portion of the third sequence. In other words, the second sequence is nested in the third sequence, thereby adapting to the requirement of IR-HARQ.

Optionally, sequence numbers in the second subset of the first sequence are N1 consecutive sequence numbers in the first sequence.

A subsequence including N1 consecutive channel sequences is read from the first sequence. For example, a length M of the first sequence is equal to 4N1. In this case, subsequences 0 to (N1-1), 1 to N1, (N1-1) to (2N1-1), ..., 3N1 to (4N1-1), and the like may be selected as the second subset, and a length of each subsequence is N1, thereby increasing the nested extraction flexibility.

Further, the N1 consecutive sequence numbers may include N1 consecutive sequence numbers starting from an (n×N1)^{th} sequence number, and n is an integer greater than or equal to 0. The N1 consecutive sequence numbers starting from the (n×N1)^{th} sequence number is from the (n×N1)^{th} sequence number to an ((n+1)×N1-1)^{th} sequence number. For example, the length M of the first sequence is equal to 4N1. In this case, subsequences 0 to (N1-1), N1 to (2N1-1), 2N1 to (3N1-1), and 3N1 to (4N1-1) may be extracted from the first sequence as the second subset, thereby increasing the nested extraction flexibility.

The second subset of the first sequence may include N1 sequence numbers, whose values are less than N1, in the first sequence. For example, the first sequence is {0, 1, 2, 4, 8, 6, 5, 9, 3, 10, 12, 7, 11, 13, 14, 15}, and a subsequence {0, 1, 2, 4, 6, 5, 3, 7} in which values of sequence numbers are less than 8 is extracted from the first sequence as the second subset, thereby increasing the nested extraction flexibility.

Optionally, the value of the sequence number in the second subset of the first sequence is greater than or equal to (M-N1). Nested extraction is performed on a sequence number whose value is greater than or equal to (M-N1) from the first sequence, to obtain the second subset including the sequence numbers of the N1 channels. In this way, subsequences with different lengths may be obtained through nested extraction to construct a codeword. This increases the nested extraction flexibility, and reduces polar code construction complexity.

Optionally, the first subset is determined from the second subset. In other words, the second subset may be first obtained through nested extraction from the first sequence, and then the first subset in which the value of the sequence number is greater than or equal to (M-N) is obtained from the second subset. In other words, in this case, the second subset of the first sequence is the same as the first sequence, thereby increasing the nested extraction flexibility.

For example, M=64, N=16, N1=32, and the first sequence with the length of 64 is:
{0, 1, 2, 4, 8, 16, 32, 3, 5, 9, 6, 17, 10, 18, 12, 33, 20, 34, 24, 36, 7, 11, 40, 19, 13, 48, 14, 21, 35, 26, 37, 25, 22, 38, 41, 28, 42, 49, 44, 50, 15, 52, 23, 56, 27, 39, 29, 43, 30, 45, 51, 46, 53, 54, 57, 58, 60, 31, 47, 55, 59, 61, 62, 63}.

A third sequence including 32 sequence numbers whose values are less than 32 is extracted from the first sequence, and the third sequence is: {0, 1 2, 4, 8, 16, 3, 5, 9, 6, 17, 10, 18, 12, 20, 24, 7, 11, 19, 13, 14, 21, 26, 25, 22, 28, 15, 23, 27, 29, 30, 31}. A second sequence {16, 17, 18, 20, 24, 19, 21, 26, 25, 22, 28, 23, 27, 29, 30, 31} is extracted from the third sequence, and a sequence of values of the sequence numbers in the second sequence corresponds to that of values of the sequence numbers in the third sequence.

Optionally, the performing, corresponding to the data retransmission, polar encoding based on the third sequence to obtain the second encoded data may include: corresponding to the data retransmission, obtaining K information bits; performing polar encoding on the K information bits based on the second sequence and the third sequence to obtain the second encoded data; and
obtaining a to-be-encoded information bit sequence, where the to-be-encoded information bit sequence may include the K information bits, and K is a positive integer less than or equal to N.

Further, the performing polar encoding on the K information bits based on the second sequence and the third sequence to obtain the second encoded data may include: constructing a first information bit position set based on the second sequence, and constructing a second information bit position set based on the third sequence, where the first information bit position set includes K channels corresponding to K sequence numbers in descending order of reliability indexes in the second sequence, the second information bit position set includes K channels corresponding to K sequence numbers in descending order of reliability indexes in the third sequence, and K is a positive integer; extracting a channel corresponding to a sequence number, whose value is less than (N1-N), in the second information bit position set, to obtain a first information bit position subset; subtracting the second information bit position set from a third information bit position set, to obtain a second information bit position subset, where a channel sequence number i in the third information bit position set is in a one-to-one correspondence with a channel sequence number j in the first information bit position set; and performing polar encoding on the K information bits based on the first information bit position set, the second information bit position set, the first information bit position subset, and the second information bit position subset, to obtain the second encoded data.

K positions with high reliability are selected as the first information bit position set ${\overline{Q}}_{{I}_{1}}^{N}$ based on the second sequence, K positions with high reliability are selected as the second information bit position set ${\overline{Q}}_{{I}_{2}}^{N 1}$ based on the third sequence. ${\overline{Q}}_{{I}_{1}}^{N}$ and ${\overline{Q}}_{{I}_{2}}^{N 1}$ are used to place the K information bits, and a remaining position is set to 0. A first information bit position subset ${\overline{Q}}_{cp}^{v}$ and a second information bit position subset ${\overline{Q}}_{cp}^{u}$ are determined based on ${\overline{Q}}_{{I}_{1}}^{N}$ and ${\overline{Q}}_{{I}_{2}}^{N 1}$. ${\overline{Q}}_{cp}^{v}$ is a subset including a channel corresponding to a sequence number, whose value is less than N1-N, in ${\overline{Q}}_{{I}_{2}}^{N 1}$, and ${\overline{Q}}_{cp}^{u}$ is a set ${\overline{Q}}_{{I}_{1}}^{N 1} - {\overline{Q}}_{{I}_{2}}^{N 1}$. Elements i in ${\overline{Q}}_{{I}_{1}}^{N 1}$ are in a one-to-one correspondence with elements j in ${\overline{Q}}_{{I}_{1}}^{N}$.

In a specific embodiment, that sequence numbers i of channels in the third information bit position set are in a one-to-one correspondence with sequence numbers j of channels in the first information bit position set may include: i = j + N. To be specific, a value of each sequence number in ${\overline{Q}}_{{I}_{1}}^{N 1}$ is equal to a value of each sequence number in ${\overline{Q}}_{{I}_{1}}^{N}$ plus N. When the second sequence is obtained by subtracting M-N from the value of each sequence number in the first subset, i = j + N.

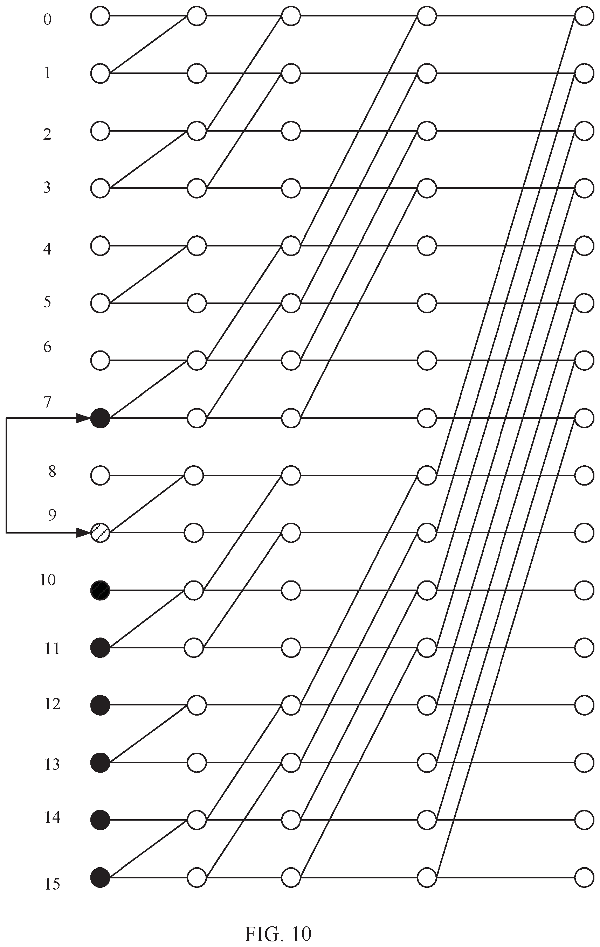

For example, as shown in FIG. 9, K=7, M=16, N=8, and N1=16. The first communication apparatus extracts, from the first sequence {0, 1, 2, 4, 8, 6, 5, 9, 3, 10, 12, 7, 11, 13, 14, 15}, a first subset {8, 9, 10, 12, 11, 13, 14, 15} in which a value of a sequence number is greater than or equal to 8, subtracts 8 from the value of each sequence number in the first subset, determines an obtained subsequence {0, 1, 2, 4, 3, 5, 6, 7} as the second sequence, extracts a second subset {0, 1, 2, 4, 8, 6, 5, 9, 3, 10, 12, 7, 11, 13, 14, 15} in which a value of a sequence number is greater than or equal to 0, subtracts 0 from the value of each sequence number in the second subset, and determines an obtained subsequence {0, 1, 2, 4, 8, 6, 5, 9, 3, 10, 12, 7, 11, 13, 14, 15} as the third sequence. Seven positions {1, 2, 4, 3, 5, 6, 7} with high reliability are selected from the second sequence as ${\overline{Q}}_{{I}_{1}}^{N}$, and seven positions {10, 12, 7, 11, 13, 14, 15} with high reliability are selected from the third sequence as ${\overline{Q}}_{{I}_{2}}^{N 1}$. ${\overline{Q}}_{cp}^{v}$ is a subset including a channel corresponding to a sequence number, whose value is less than 8, in ${\overline{Q}}_{{I}_{2}}^{N 1}$, that is, ${\overline{Q}}_{cp}^{v} = \left\{7\right\}$. A value of each sequence number in ${\overline{Q}}_{{I}_{1}}^{N 1}$ is equal to a value of each sequence number in ${\overline{Q}}_{{I}_{1}}^{N}$ plus 8, that is, ${\overline{Q}}_{{I}_{1}}^{N 1} = \left\{9, 10, 12, 11, 13, 14, 15\right\}$, and ${\overline{Q}}_{cp}^{u} = {\overline{Q}}_{{I}_{1}}^{N 1} - {\overline{Q}}_{{I}_{2}}^{N 1} = \left\{9\right\}$. As shown in FIG. 10, ${\overline{Q}}_{cp}^{u}$ corresponds to a shadow-filled bit position {9} in the figure, and ${\overline{Q}}_{cp}^{v}$ corresponds to a black-filled bit position {7} corresponding to the shadow-filled bit position {9} in the figure.

In another specific embodiment, that the sequence numbers i of the channels in the third information bit position set are in a one-to-one correspondence with the sequence numbers j of the channels in the first information bit position set may include: i = j.

For example, M=16, N=8, and N1=16. The first communication apparatus extracts, from the first sequence {0, 1, 2, 4, 8, 6, 5, 9, 3, 10, 12, 7, 11, 13, 14, 15}, the first subset {8, 9, 10, 12, 11, 13, 14, 15} in which the value of the sequence number is greater than or equal to 8, determines the first subset as the second sequence, extracts the second subset {0, 1, 2, 4, 8, 6, 5, 9, 3, 10, 12, 7, 11, 13, 14, 15} in which the value of the sequence number is greater than or equal to 0, and determines the second subset as the third sequence. Seven positions {9, 10, 12, 11, 13, 14, 15} with high reliability are selected from the second sequence as ${\overline{Q}}_{{I}_{1}}^{N}$, and seven positions {10, 12, 7, 11, 13, 14, 15} with high reliability are selected from the third sequence as ${\overline{Q}}_{{I}_{2}}^{N 1}$. ${\overline{Q}}_{cp}^{v}$ is the subset including the channel corresponding to the sequence number, whose value is less than 8, in ${\overline{Q}}_{{I}_{2}}^{N 1}$, that is, ${\overline{Q}}_{cp}^{v} = \left\{7\right\}$. ${\overline{Q}}_{{I}_{1}}^{N 1}$ is equal to ${\overline{Q}}_{{I}_{1}}^{N}$, both are t9, 10, 12, 11, 13, 14, 151, and ${\overline{Q}}_{cp}^{u} = {\overline{Q}}_{{I}_{1}}^{N 1} - {\overline{Q}}_{{I}_{2}}^{N 1} = \left\{9\right\}$.

S804: The second communication apparatus obtains first to-be-decoded information.

The first to-be-decoded information may be information received by the second communication apparatus after the first encoded data is adjusted and sent by the first communication apparatus.

S805: The second communication apparatus decodes the first to-be-decoded information based on the second sequence.

The second sequence may include the sequence numbers of the N channels, the second sequence is determined based on the first subset of the first sequence, the first sequence includes the sequence numbers of the M channels, the sequence numbers of the M channels are arranged in the first sequence in ascending order of the channel reliability, the first subset includes N sequence numbers, and a value of the sequence number in the first subset is greater than or equal to (M-N).

S806: The second communication apparatus outputs data obtained through decoding of the first to-be-decoded information.

A specific implementation principle of S804 to S806 is similar to that of S801 to S803, and reference may be made for understanding. Details are not described herein again.

In conclusion, nested extraction is performed on a sequence number whose value is greater than or equal to (M-N) from the first sequence, to obtain the first subset including the sequence numbers of the N channels, the second sequence with the length of N is determined based on the first subset, and polar encoding is further performed based on the second sequence. In this way, there is no need to store one sequence for each length. A latter portion of the first sequence is extracted, so that subsequences with different lengths may be obtained through nested extraction to construct a codeword. This increases the nested extraction flexibility, and reduces polar code construction complexity.

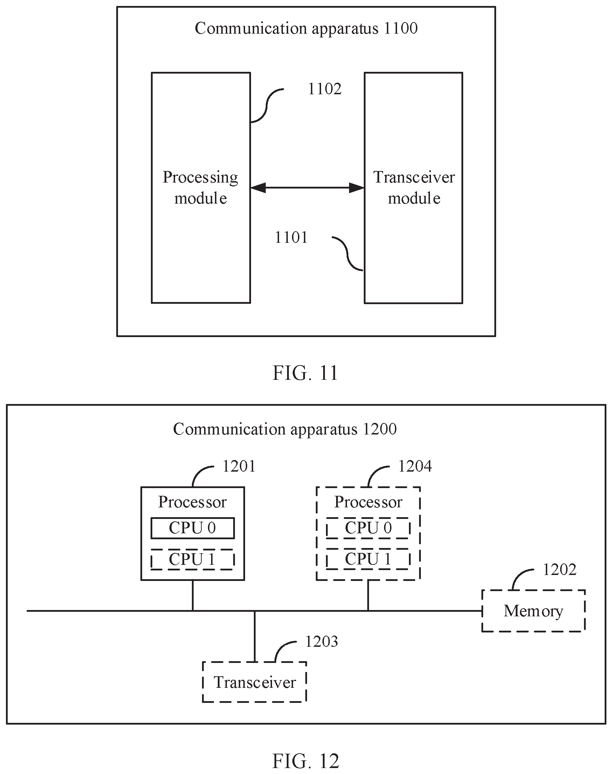

The foregoing describes in detail the method provided in embodiments of this application with reference to FIG. 8 to FIG. 10. With reference to FIG. 11 and FIG. 12, the following describes in detail communication apparatuses configured to perform the polar-code coding method provided in embodiments of this application.

FIG. 11 is a diagram 1 of a structure of a communication apparatus according to an embodiment of this application. For example, as shown in FIG. 11, the communication apparatus 1100 includes a transceiver module 1101 and a processing module 1102. For ease of description, FIG. 11 shows only main components of the communication apparatus.

The transceiver module 1101 is configured to perform transceiver function in the method shown in FIG. 8, and the processing module 1102 is configured to perform a function other than the transceiver function in the method shown in FIG. 8.

Optionally, the transceiver module 1101 may include a sending module (not shown in FIG. 11) and a receiving module (not shown in FIG. 11). The sending module is configured to implement a sending function of the communication apparatus 1100, and the receiving module is configured to implement a receiving function of the communication apparatus 1100.

Optionally, the communication apparatus 1100 may further include a storage module (not shown in FIG. 11), and the storage module stores a program or instructions. When the processing module 1102 executes the program or the instructions, the communication apparatus 1100 is enabled to perform a function of the terminal or the network device in the method shown in FIG. 8 in the foregoing methods.

It may be understood that the communication apparatus 1100 may be a terminal or a network device, may be a chip (system) or another component or assembly that may be disposed in the terminal or the network device, or may be an apparatus that includes the terminal or the network device. This is not limited in this application.

In addition, for technical effects of the communication apparatus 1100, reference may be made to the technical effects of the polar-code coding method shown in FIG. 8 to FIG. 10. Details are not described herein again.

FIG. 12 is a diagram 2 of a structure of a communication apparatus according to an embodiment of this application. For example, the communication apparatus may be a terminal, or may be a chip (system) or another component or assembly that may be disposed in the terminal. As shown in FIG. 12, the communication apparatus 1200 may include a processor 1201. Optionally, the communication apparatus 1200 may further include a memory 1202 and/or a transceiver 1203. The processor 1201 is coupled to the memory 1202 and/or the transceiver 1203. For example, the processor 1201 may be connected to the memory 1202 and/or the transceiver 1203 through a communication bus, through an intra-chip interface, or through another communication line. Optionally, the memory 1202 may be integrated with the processor 1201.

The following specifically describes the components of the communication apparatus 1200 with reference to FIG. 12.

The processor 1201 is a control center of the communication apparatus 1200, and may be a processor or a generic term of a plurality of processing elements. For example, the processor 1201 is one or more central processing units (central processing units, CPUs), or may be an application-specific integrated circuit (application-specific integrated circuit, ASIC), or one or more integrated circuits configured to implement embodiments of this application, for example, one or more microprocessors (digital signal processors, DSPs) or one or more field programmable gate arrays (field programmable gate arrays, FPGAs).

Optionally, the processor 1201 may perform various functions of the communication apparatus 1200, for example, perform the foregoing polar-code coding method shown in FIG. 8, by running or executing a software program stored in the memory 1202 and invoking data stored in the memory 1202.

In a specific implementation, in an embodiment, the processor 1201 may include one or more CPUs, for example, a CPU 0 and a CPU 1 shown in FIG. 12.

During specific implementation, in an embodiment, the communication apparatus 1200 may also include a plurality of processors, for example, the processor 1201 and a processor 1204 shown in FIG. 12. Each of the processors may be a single-core processor (single-CPU), or may be a multi-core processor (multi-CPU). The processor herein may be one or more devices, circuits, and/or processing cores configured to process data (for example, computer program instructions).

The memory 1202 is configured to store the software program for performing the solutions in this application, and the processor 1201 controls execution. For a specific implementation, refer to the foregoing method embodiments. Details are not described herein again.

Optionally, the memory 1202 may be a read-only memory (read-only memory, ROM), another type of static storage device that can store static information and instructions, a random access memory (random access memory, RAM), or another type of dynamic storage device that can store information and instructions, or may be an electrically erasable programmable read-only memory (electrically erasable programmable read-only memory, EEPROM), a compact disc read-only memory (compact disc read-only memory, CD-ROM), another compact disc storage, an optical disc storage (including a compact disc, a laser disc, an optical disc, a digital versatile disc, a Blu-ray disc, or the like), a magnetic disk storage medium, another magnetic storage device, or any other medium that can be used to carry or store expected program code in a form of instructions or data structure and that can be accessed by a computer. However, this is not limited thereto. The memory 1202 may be integrated with the processor 1201, or may exist independently, and is coupled to the processor 1201 through an interface circuit (not shown in FIG. 12) of the communication apparatus 1200. This is not specifically limited in embodiments of this application.

The transceiver 1203 is configured to communicate with another communication apparatus. For example, the communication apparatus 1200 is a terminal, and the transceiver 1203 may be configured to communicate with a network device or communicate with another terminal device. For another example, the communication apparatus 1200 is a network device, and the transceiver 1203 may be configured to communicate with a terminal or communicate with another network device.

Optionally, the transceiver 1203 may include a receiver and a transmitter (not separately shown in FIG. 12). The receiver is configured to implement a receiving function, and the transmitter is configured to implement a sending function.

Optionally, the transceiver 1203 may be integrated with the processor 1201, or may exist independently, and is coupled to the processor 1201 through an interface circuit (not shown in FIG. 12) of the communication apparatus 1200. This is not specifically limited in embodiments of this application.

It can be understood that the structure of the communication apparatus 1200 shown in FIG. 12 does not constitute any limitation on the communication apparatus. An actual communication apparatus may include more or fewer components than those shown in the figure, combine some components, or have different component arrangements.

In addition, for technical effects of the communication apparatus 1200, reference may be made to the technical effects of the method in the foregoing method embodiments. Details are not described herein again.

It should be understood that, the processor in embodiments of this application may be a central processing unit (central processing unit, CPU), or the processor may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, or the like. The general-purpose processor may be a microprocessor, or the processor may be any conventional processor or the like.

It may be understood that the memory in embodiments of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache. Through an example rather than a limitative description, random access memories (random access memories, RAMs) in a plurality of forms may be used, for example, a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

All or a part of the foregoing embodiments may be implemented by software, hardware (for example, a circuit), firmware, or any combination thereof. When software is used to implement embodiments, all or a part of the foregoing embodiments may be implemented in a form of computer program product. The computer program product includes one or more computer instructions or computer programs. When the computer instructions or the computer programs are loaded or executed on a computer, all or a part of the procedures or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, infrared, radio, microwave, or the like) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), or a semiconductor medium. The semiconductor medium may be a solid-state drive.

It should be understood that the term "and/or" in this specification describes only an association relationship between associated objects and indicates that three relationships may exist. For example, A and/or B may indicate the following three cases: only A exists, both A and B exist, and only B exists, where A and B may be singular or plural. In addition, the character "/" in this specification usually indicates an "or" relationship between associated objects, but may also indicate an "and/or" relationship. For details, refer to the context for understanding.

In this application, "at least one" means one or more, and "a plurality of" means two or more. "At least one of the following items (pieces)" or a similar expression thereof means any combination of these items, including a singular item (piece) or any combination of plural items (pieces). For example, at least one of a, b, or c may indicate: a, b, c, a and b, a and c, b and c, or a, b, and c, where a, b, and c may be singular or plural.

It should be understood that sequence numbers of the foregoing processes do not mean execution sequences in various embodiments of this application. The execution orders of the processes should be determined according to functions and internal logic of the processes, and should not be construed as any limitation on the implementation processes of embodiments of this application.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, reference may be made to a corresponding process in the foregoing method embodiments. Details are not described herein again.

In several embodiments provided in this application, it should be understood that the disclosed system, apparatus, and method may be implemented in other manners. For example, the foregoing apparatus embodiments are merely examples. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between apparatuses or units may be implemented in electronic, mechanical, or other forms.

The units described as separate components may or may not be physically separate, and components displayed as units may or may not be physical units, may be located in one position, or may be distributed on a plurality of network units. A part or all of the units may be selected according to actual requirements to achieve the objectives of the solutions of embodiments.

In addition, functional units in embodiments of this application may be integrated into one processing unit, each of the units may exist alone physically, or two or more units are integrated into one unit.

When the functions are implemented in a form of software functional unit and sold or used as an independent product, the functions may be stored in a computer-readable storage medium. Based on such an understanding, the technical solutions of this application essentially, or the part contributing to the conventional technology, or a part of the technical solutions may be implemented in a form of software product. The computer software product is stored in a storage medium, and includes several instructions for instructing a computer device (which may be a personal computer, a server, a network device, or the like) to perform all or a part of the steps of the methods described in embodiments of this application. The foregoing storage medium includes any medium that can store program code, for example, a USB flash drive, a removable hard disk, a read-only memory (read-only memory, ROM), a random access memory (random access memory, RAM), a magnetic disk, or an optical disc.

## Claims

1. A polar code encoding method, comprising:
obtaining a first sequence, wherein the first sequence comprises sequence numbers of M channels, and the sequence numbers of the M channels are arranged in the first sequence in ascending order of channel reliability;
performing polar encoding based on a second sequence to obtain first encoded data, wherein the second sequence comprises sequence numbers of N channels, the second sequence is determined based on a first subset of the first sequence, the first subset comprises N sequence numbers, and a value of the sequence number in the first subset is greater than or equal to (M-N); and
outputting the first encoded data.

2. The method according to claim 1, wherein the method further comprises:
performing, corresponding to data retransmission, polar encoding based on a third sequence to obtain second encoded data, wherein the third sequence comprises sequence numbers of N1 channels, the third sequence is determined based on a second subset of the first sequence, the second subset comprises N1 sequence numbers, the third sequence corresponds to the second sequence, and N is less than or equal to N1.

3. The method according to claim 1, wherein that the second sequence is determined based on the first subset of the first sequence comprises:
the second sequence is the first subset of the first sequence; or
the second sequence is the same as a sequence obtained by subtracting (M-N) from a value of each sequence number in the first subset of the first sequence.

4. The method according to claim 2, wherein that the third sequence is determined based on the second subset of the first sequence comprises:
the third sequence is the second subset of the first sequence; or
the third sequence is the same as a sequence obtained by subtracting (M-N1) from a value of each sequence number in the second subset of the first sequence.

5. The method according to claim 2, wherein sequence numbers in the second subset of the first sequence are N1 consecutive sequence numbers in the first sequence.

6. The method according to claim 5, wherein the N1 consecutive sequence numbers comprise N1 consecutive sequence numbers starting from an (n×N1)^{th} sequence number, and n is an integer greater than or equal to 0.

7. The method according to claim 2, wherein the second subset of the first sequence comprises N1 sequence numbers, whose values are less than N1, in the first sequence.

8. The method according to claim 2, wherein the performing, corresponding to the data retransmission, polar encoding based on the third sequence to obtain the second encoded data comprises:
corresponding to the data retransmission, obtaining K information bits; and
performing polar encoding on the K information bits based on the second sequence and the third sequence to obtain the second encoded data.

9. The method according to claim 8, wherein the performing polar encoding on the K information bits based on the second sequence and the third sequence to obtain the second encoded data comprises:
constructing a first information bit position set based on the second sequence, and constructing a second information bit position set based on the third sequence, wherein the first information bit position set comprises K channels corresponding to K sequence numbers in descending order of reliability indexes in the second sequence, the second information bit position set comprises K channels corresponding to K sequence numbers in descending order of reliability indexes in the third sequence, and K is a positive integer;
extracting a channel corresponding to a sequence number, whose value is less than (N1-N), in the second information bit position set, to obtain a first information bit position subset;
subtracting the second from a third information bit position set, to obtain a second information bit position subset, wherein a channel sequence number i in the third information bit position set is in a one-to-one correspondence with a channel sequence number j in the first information bit position set; and
performing polar encoding on the K information bits based on the first information bit position set, the second information bit position set, the first information bit position subset, and the second information bit position subset, to obtain the second encoded data.

10. A polar code decoding method, comprising:
obtaining first to-be-decoded information;
decoding the first to-be-decoded information based on a second sequence, wherein the second sequence comprises sequence numbers of N channels, the second sequence is determined based on a first subset of a first sequence, the first sequence comprises sequence numbers of M channels, the sequence numbers of the M channels are arranged in the first sequence in ascending order of channel reliability, the first subset comprises N sequence numbers, and a value of the sequence number in the first subset is greater than or equal to (M-N); and
outputting data obtained through decoding of the first to-be-decoded information.

11. The method according to claim 10, wherein the method further comprises:
corresponding to data retransmission, obtaining a second to-be-decoded information;
decoding the second to-be-decoded information based on a third sequence, wherein the third sequence comprises sequence numbers of N1 channels, the third sequence is determined based on a second subset of the first sequence, the second subset comprises N1 sequence numbers, the third sequence corresponds to the second sequence, and N is less than or equal to N1; and
outputting data obtained through decoding of the second to-be-decoded information.

12. The method according to claim 10, wherein that the second sequence is determined based on the first subset of the first sequence comprises:
the second sequence is the first subset of the first sequence; or
the second sequence is the same as a sequence obtained by subtracting (M-N) from a value of each sequence number in the first subset of the first sequence.

13. The method according to claim 11, wherein that the third sequence is determined based on the second subset of the first sequence comprises:
the third sequence is the second subset of the first sequence; or
the third sequence is the same as a sequence obtained by subtracting (M-N1) from a value of each sequence number in the second subset of the first sequence.

14. The method according to claim 11, wherein sequence numbers in the second subset of the first sequence are N1 consecutive sequence numbers in the first sequence.

15. The method according to claim 11, wherein the second subset of the first sequence comprises an (n×N1)^{th} sequence number to an ((n+1)×N1)^{th} sequence number in the first sequence, and n is an integer greater than or equal to 0.

16. The method according to claim 11, wherein the second subset of the first sequence comprises N1 sequence numbers, whose values are less than N1, in the first sequence.

17. The method according to claim 11, wherein the decoding the second to-be-decoded information based on the third sequence comprises:
decoding the second to-be-decoded information based on the second sequence and the third sequence.

18. The method according to claim 17, wherein the decoding the second to-be-decoded information based on the second sequence and the third sequence comprises:
constructing a first information bit position set based on the second sequence, and constructing a second information bit position set based on the third sequence, wherein the first information bit position set comprises K channels corresponding to K sequence numbers in descending order of reliability indexes in the second sequence, the second information bit position set comprises K channels corresponding to K sequence numbers in descending order of reliability indexes in the third sequence, and K is a positive integer;
extracting a channel corresponding to a sequence number, whose value is less than (N1-N), in the second information bit position set, to obtain a first information bit position subset;
subtracting the second information bit position set from a third information bit position set, to obtain a second information bit position subset, wherein a channel sequence number i in the third information bit position set is in a one-to-one correspondence with a channel sequence number j in the first information bit position set; and
decoding the second to-be-decoded information based on the first information bit position set, the second information bit position set, the first information bit position subset, and the second information bit position subset.

19. A communication apparatus, wherein the communication apparatus comprises a processor and a memory, the memory is configured to store computer instructions, and when the processor executes the instructions, the method according to any one of claims 1 to 18 is performed.

20. A communication system, wherein the communication apparatus comprises a terminal and a network device, and the terminal and the network device are configured to perform the method according to any one of claims 1 to 18.

21. A computer-readable storage medium, wherein the computer-readable storage medium comprises a computer program or instructions, and when the computer program or the instructions are run on a computer, the computer is enabled to perform the method according to any one of claims 1 to 18.
